# FASCICULE DE BREVET EUROPEEN

(11) **EP 2 081 216 B1**
(45) Date de publication et mention de la délivrance du brevet: **10.04.2019**
(21) Numéro de dépôt: 09150381.3
(22) Date de dépôt: 12.01.2009
(51) Int. Cl.: H01L 21/312, H01L 21/316, H01L 21/768

(54) **Procédé de fabrication de films diélectriques perméables**
Verfahren zur Herstellung von durchlässigen dielektrischen Folien
Method for manufacturing permeable dielectric films

(30) Priorité: 16.01.2008 FR 0850248
(43) Date de publication de la demande: 22.07.2009
(73) Titulaire: Commissariat à l'Énergie Atomique et aux Énergies Alternatives, 75015 Paris (FR)
(72) Inventeur: Jousseaume, Vincent, 38700 Le Sappey en Chartreuse (FR)
(74) Mandataire: Ilgart, Jean-Christophe

(56) Documents cités:
- EP-A- 1 457 583
- JP-A- 2007 311 777
- US-A1- 2002 022 378
- US-A1- 2005 074 961

## Description

### DOMAINE TECHNIQUE

La présente invention se rapporte à un procédé de fabrication de films diélectriques qui ont, en autres propriétés, celle d'être perméables aux agents classiquement employés pour réaliser des attaques chimiques dans l'industrie des semi-conducteurs comme, par exemple, l'acide fluorhydrique, tout en étant résistants à ces agents. Ces films présentent, en outre, une faible permittivité ("*low-k*"), c'est-à-dire une constante diélectrique *k* généralement inférieure ou égale à 4,0.

De par leurs propriétés, ces films sont susceptibles d'être utilisés en microélectronique et en microtechnologie, dans tous les processus de fabrication qui font intervenir la dégradation d'un matériau sacrificiel par diffusion d'un agent d'attaque chimique au travers d'un film perméable à cet agent pour la réalisation de cavités d'air. A titre d'exemples, de tels processus sont mis en oeuvre dans la fabrication d'interconnexions à cavités d'air (ou « air-gaps » en anglais) pour circuit intégré, de microsystèmes électromécaniques (MEMS) à cavités résonantes du type BAW (« Bulk Acoustic Wave »), ainsi que de microbatteries.

### ÉTAT DE LA TECHNIQUE ANTERIEURE

La fabrication de dispositifs en microélectronique ou en microtechnologie nécessite, dans les solutions les plus avancées, la réalisation de cavités d'air.

Pour réaliser ces cavités d'air, l'une des approches actuelles consiste à dégrader un matériau sacrificiel, typiquement de l'oxyde de silicium, au moyen d'un agent d'attaque chimique, par exemple de l'acide fluorhydrique, qui doit traverser une membrane film pour atteindre ce matériau.

Outre d'être capable de laisser passer l'agent d'attaque chimique, cette membrane doit répondre à un cahier des charges très précis, à savoir :
- résister elle-même à l'agent d'attaque chimique,
- être compatible avec les différents procédés et traitements mis en oeuvre pour réaliser la structure dans laquelle elle est intégrée (métallisations, polissages mécano-chimiques, recuits thermiques, ......) et, en particulier, être stable à des températures pouvant atteindre 400°C,
- avoir des propriétés mécaniques satisfaisantes puisqu'elle participe à l'ossature de la structure, et
- présenter une constante diélectrique faible, c'est-à-dire au plus égale à 4,0, dans le cas d'une structure d'interconnexions pour circuit intégré.

Les membranes perméables actuellement utilisées sont généralement en des matériaux polymères du type polyphénylène que l'on dépose par la technique de dépôt par centrifugation (ou « spin-coating » en anglais). Ces matériaux polymères ont un coefficient de dilatation thermique important et des propriétés mécaniques faibles. Ainsi, leur dilatation lors des étapes de recuit thermique engendre des contraintes dans les structures qui peuvent aboutir à des délaminations aux interfaces.

De plus, la technique de dépôt par centrifugation n'est pas une technique que l'industrie des semi-conducteurs privilégie dans le cas de matériaux qui sont destinés à rester dans des dispositifs, les techniques de dépôt chimique ou physique en phase vapeur leur étant nettement préférées.

Le documents US 2002/022378 A1 divulgue un procédé de fabrication d'un film diélectrique à base d'un matériau Si:O:C:H comprenant la destruction sélective par un agent chimique.

Le document JP 2007/311777 A divulgue un procédé de fabrication d'un film diélectrique à base d'un matériau Si:O:C:H comprenant la destruction sélective par un agent chimique ainsi que son emploi comme membrane.

### EXPOSÉ DE L'INVENTION

L'invention a précisément pour objet un procédé qui permet de fabriquer un film diélectrique satisfaisant à toutes les exigences du cahier des charges précédemment mentionné et ce, sans recourir à la technique de dépôt par centrifugation.

Ce procédé comprend :
a) le dépôt sur un substrat d'un film en un matériau comprenant du silicium, du carbone, de l'hydrogène, de l'oxygène et, éventuellement, de l'azote et/ou du fluor, une majorité de liaisons silicium-carbone et une proportion de liaisons silicium-oxygène telle que l'oxygène présent dans ledit matériau représente au plus 30% en nombre d'atomes ; puis
b) la destruction sélective par un agent chimique des liaisons silicium-oxygène présentes dans le film formé à l'étape a), ce qui permet de conférer à ce film une porosité ouverte sur la totalité de son épaisseur et, ainsi, de le rendre perméable.

Dans ce qui précède et ce qui suit, on considère qu'un matériau comprend une majorité de liaisons silicium-carbone lorsque plus de 50% des liaisons faites par les atomes de silicium présents dans ce matériau sont des liaisons silicium-carbone.

Conformément à l'invention, le matériau comprenant du silicium, du carbone, de l'hydrogène, de l'oxygène et, éventuellement, de l'azote et/ou du fluor est, de préférence, de type SiᵥC_{w}H_{y}O_{z} ou SiᵥC_{w}NₓH_{y}O_{z} avec v, w, x, y et z tous différents de 0.

Des films constitués d'un matériau de ce type peuvent être déposés sur un substrat notamment par la technique de dépôt chimique en phase vapeur assisté par plasma, plus connue sous le sigle PECVD pour « **P**lasma **E**nhanced **C**hemical **V**apor **D**eposition ».

Pour obtenir un film de type SiᵥC_{w}H_{y}O_{z}, on utilise alors, de préférence, un plasma contenant un premier précurseur organosilicié exempt d'oxygène et un deuxième précurseur constitué d'oxygène, seul ou en combinaison avec du carbone et/ou de l'hydrogène, tandis que, pour obtenir un film de type SiᵥC_{w}NₓH_{y}O_{z}, on préfère ajouter à ce plasma un troisième précurseur constitué d'azote, seul ou en combinaison avec de l'hydrogène et/ou du carbone.

A titre d'exemple, le premier précurseur peut être un alkylsilane tel que le diméthylsilane, le triméthylsilane ou encore le tétraméthylsilane ; le deuxième précurseur peut être de l'oxygène ou du dioxyde de carbone, tandis que le troisième précurseur peut être de l'azote ou de l'ammoniac.

Dans tous les cas, les proportions des différents précurseurs dans le plasma sont convenablement choisies pour que la concentration atomique de l'oxygène soit inférieure à 30% dans le film obtenu à l'issue de l'étape a).

En variante, il est également possible d'obtenir un film de type SiᵥC_{w}H_{y}O_{z} avec un plasma ne contenant qu'un seul précurseur constitué à la fois par du silicium, du carbone, de l'hydrogène et de l'oxygène mais ayant une teneur en oxygène inférieure ou égale à 30% atomique comme, par exemple, le diéthoxy-méthylsilane ou l'octaméthylcyclotétrasiloxane. De manière similaire, il est possible d'obtenir un film de type SiᵥC_{w}NₓH_{y}O_{z} en utilisant ce précurseur conjointement avec un autre précurseur constitué d'azote, seul ou en combinaison avec de l'hydrogène et/ou du carbone.

Conformément à l'invention, le plasma peut, en outre, contenir un ou plusieurs gaz vecteurs inertes, en particulier de l'hélium et/ou de l'argon.

Le dépôt du film par PECVD peut notamment être réalisé dans un réacteur à couplage capacitif. Les paramètres opératoires sont alors, de préférence, les suivants : une excitation de type radiofréquence à 13,56 MHz ; une puissance comprise entre 100 et 900 W, une température comprise entre 100 et 450°C pour une pression comprise entre 1 et 10 torrs (0,133 à 1,33 kPa) et des débits de précurseurs compris entre 1 et 10000 cm³/minute.

Au terme de ce dépôt, les caractéristiques du film et, notamment, sa concentration atomique en oxygène peuvent être vérifiées par des méthodes d'analyse de composition telles que la spectroscopie infrarouge en transmission.

Conformément à l'invention, le film présente, de préférence, une épaisseur allant de 10 nm à 10 µm et, mieux encore, de 100 nm à 1 µm.

Comme précédemment indiqué, on procède ensuite à une destruction sélective des liaisons silicium-oxygène au moyen d'un agent chimique pour rendre le film perméable. Cet agent chimique doit donc être capable d'attaquer les liaisons silicium-oxygène présentes dans ce film tout en conservant intactes les autres liaisons et, en particulier, les liaisons silicium-carbone, silicium-hydrogène et carbone-hydrogène.

Un composé chimique ayant cette propriété est notamment l'acide fluorhydrique qui est couramment employé dans l'industrie des semiconducteurs et dont l'utilisation est donc parfaitement maîtrisée.

Aussi, l'agent chimique utilisé à l'étape b) est-il, de préférence, un fluide contenant de l'acide fluorhydrique.

Conformément à l'invention, ce fluide est, de préférence, une solution aqueuse ou organique d'acide fluorhydrique, par exemple à 1 ou quelques % (v/v) d'HF, auquel cas l'étape b) peut être réalisée par simple trempage du film dans cette solution.

Toutefois, il peut également s'agir d'acide fluorhydrique gazeux, pur ou mélangé à un gaz porteur tel que l'azote, ou d'un mélange d'acide fluorhydrique et de dioxyde de carbone supercritique, par exemple dans un rapport de 1/100 (v/v).

En variante, l'agent chimique peut également être un fluide contenant du fluorure d'ammonium, éventuellement en mélange avec de l'acide fluorhydrique.

Conformément à l'invention, le substrat est avantageusement un substrat de silicium comportant ou non des structures en oxyde de silicium. Ainsi, le substrat peut notamment être un substrat de silicium comprenant un niveau d'interconnexions formé de lignes métalliques, par exemple en cuivre, noyées dans une couche d'oxyde de silicium.

En plus des avantages précédemment mentionnés, le procédé selon l'invention présente encore l'avantage d'être simple à mettre en oeuvre, notamment parce que l'étape a) de dépôt consiste à ne déposer sur le substrat qu'un seul matériau.

D'autres caractéristiques et avantages de l'invention apparaîtront mieux à la lecture du complément de description qui suit et qui se rapporte à des exemples de mise en oeuvre du procédé selon l'invention.

Bien entendu, ces exemples ne sont donnés qu'à titre d'illustrations de l'objet de l'invention et ne constituent en aucun cas une limitation de cet objet.

### EXPOSÉ DÉTAILLÉ DE MODES DE MISE EN ŒUVRE PARTICULIERS

### Exemple 1 :

On dépose, sur un substrat en silicium, une couche mince de 100 nm d'épaisseur de SiᵥC_{w}NₓH_{y}O_{z}, présentant une teneur en oxygène de l'ordre de 10 à 20% atomique, par PECVD à partir de tétraméthylsilane, d'oxygène, d'ammoniac et d'hélium.

Le dépôt est réalisé dans l'une des chambres de dépôt PECVD à couplage capacitif d'une Centura® 5200 DxZ de la société Applied Materials, en utilisant les paramètres opératoires suivants :
Excitation radiofréquence : 13,56 MHz
Pression de travail : 3 torrs (0,4 kPa)
Puissance : 310 W
Température de dépôt : 350°C
Flux de tétraméthylsilane : 80 cm³/min
Flux d'oxygène : 10 cm³/min
Flux d'ammoniac : 160 cm³/min
Flux d'hélium : 200 cm³/min
Durée du dépôt : 1 minute.

A l'issue du dépôt, la couche mince et le substrat sous-jacent sont immergés dans une solution aqueuse à 1% (v/v) d'HF pendant 10 minutes.

On obtient ainsi, sur le substrat, un film diélectrique qui présente une constante diélectrique (mesurée avec une sonde au mercure) inférieure à 4,0 et une porosité ouverte estimée à 15%.

### Exemple 2 :

On dépose, sur un substrat en silicium comprenant une pluralité de plots en métal ou en matériau diélectrique noyés dans une couche de SiO₂, une couche mince de 200 nm d'épaisseur de SiᵥC_{w}H_{y}O_{z}, présentant une teneur en oxygène de l'ordre de 15% atomique, par PECVD à partir de triméthylsilane, de CO₂ et d'hélium.

Le dépôt est réalisé dans l'une des chambres de dépôt PECVD à couplage capacitif d'un Producer SE 300 mm de la société Applied Materials, en utilisant les paramètres opératoires suivants :
Excitation radiofréquence : 13,56 MHz
Pression de travail : 8,7 torrs (1,06 kPa)
Puissance : 585 W
Température de dépôt : 350°C
Flux de triméthylsilane : 210 cm³/min
Flux de dioxyde de carbone : 10 cm³/min
Flux d'hélium : 600 cm³/min
Durée du dépôt : 1 minute.

A l'issue du dépôt, la couche mince et le substrat sous-jacent sont immergés dans une solution aqueuse à 1% (v/v) d'acide fluorhydrique pendant 20 minutes, ce temps étant déterminé en fonction de l'épaisseur des zones de SiO₂ à dissoudre (environ 1 minute pour 10 nm de SiO₂) et en comptant 5 minutes de traitement pour la destruction des liaisons Si-O de la couche mince.

On obtient ainsi un film diélectrique libéré (du fait de la dissolution des zones de SiO₂) tout en étant maintenu sur le substrat par les plots métalliques ou diélectriques de ce substrat. Ce film présente une constante diélectrique (mesurée avec une sonde au mercure) inférieure à 4,0 et une porosité ouverte estimée à 10%.

## Revendications

1. Procédé de fabrication d'un film diélectrique perméable, qui comprend :
a) le dépôt sur un substrat d'un film constitué d'un matériau comprenant du silicium, du carbone, de l'hydrogène, de l'oxygène et, éventuellement, de l'azote et/ou du fluor, dans lequel plus de 50% des liaisons formées par les atomes de silicium sont des liaisons silicium-carbone et dans lequel la proportion de liaisons silicium-oxygène est telle que l'oxygène présent dans ledit matériau représente moins de 30% en nombre d'atomes ; puis
b) la destruction sélective par un agent chimique des liaisons silicium-oxygène présentes dans le film déposé à l'étape a).

2. Procédé selon la revendication 1, dans lequel le matériau constituant le film est de type SiᵥC_{w}H_{y}O_{z} ou SiᵥC_{w}NₓH_{y}O_{z} avec v, w, x, y et z tous différents de 0.

3. Procédé selon la revendication 1 ou la revendication 2, dans lequel le film est déposé sur le substrat par dépôt chimique en phase vapeur assisté par plasma.

4. Procédé selon la revendication 3, dans lequel le film est de type SiᵥC_{w}H_{y}O_{z} et son dépôt sur le substrat est réalisé en utilisant un plasma contenant un premier précurseur organosilicié exempt d'oxygène et un deuxième précurseur constitué d'oxygène, seul ou en combinaison avec du carbone et/ou de l'hydrogène.

5. Procédé selon la revendication 4, dans lequel le premier précurseur est un alkylsilane et le deuxième précurseur est de l'oxygène ou du dioxyde de carbone.

6. Procédé selon la revendication 3, dans lequel le film est de type SiᵥC_{w}NₓH_{y}O_{z} et son dépôt sur le substrat est réalisé en utilisant un plasma contenant un premier précurseur organosilicié exempt d'oxygène, un deuxième précurseur constitué d'oxygène, seul ou en combinaison avec du carbone et/ou de l'hydrogène et un troisième précurseur constitué d'azote, seul ou en combinaison avec de l'hydrogène et/ou du carbone.

7. Procédé selon la revendication 6, dans lequel le premier précurseur est un alkylsilane, le deuxième précurseur est de l'oxygène ou du dioxyde de carbone et le troisième précurseur est de l'azote ou de l'ammoniac.

8. Procédé selon l'une quelconque des revendications précédentes, dans lequel l'agent chimique utilisé à l'étape b) est un fluide contenant de l'acide fluorhydrique.

9. Procédé selon la revendication 8, dans lequel le fluide contenant de l'acide fluorhydrique est une solution aqueuse ou organique d'acide fluorhydrique.

10. Procédé selon la revendication 8, dans lequel le fluide contenant de l'acide fluoryhydrique est de l'acide fluorhydrique gazeux pur, un mélange d'acide flurohydrique gazeux et d'un gaz porteur, ou bien un mélange d'acide fluorhydrique et de dioxyde de carbone supercritique.

11. Procédé selon l'une quelconque des revendications 1 à 7, dans lequel l'agent chimique utilisé à l'étape b) est un fluide contenant du fluorure d'ammonium.

12. Procédé selon l'une quelconque des revendications précédentes, dans lequel le substrat est un substrat de silicium comportant ou non des structures en oxyde de silicium.

13. Procédé selon l'une quelconque des revendications précédentes, qui conduit à l'obtention d'un film diélectrique présentant une constante diélectrique k inférieure ou égale à 4,0.

14. Procédé de fabrication d'interconnexions à cavités d'air pour circuit intégré, qui comprend la mise en oeuvre d'un procédé selon l'une quelconque des revendications 1 à 13.

## Patentansprüche

1. Verfahren zum Herstellen einer durchlässigen, dielektrischen Folie, umfassend:
a) Abscheiden einer Folie aus einem Material, das Silicium, Kohlenstoff, Wasserstoff, Sauerstoff und gegebenenfalls Stickstoff und/oder Fluor enthält, auf ein Substrat, wobei mehr als 50% durch die Siliciumatome gebildeten Bindungen Silicium-Kohlenstoff-Bindungen sind und wobei der Anteil an Silicium-Sauerstoff-Bindungen derart ist, dass der in dem Material vorhandene Sauerstoff weniger als 30 Atomprozent beträgt; dann
b) selektives Zerstören der in der in Schritt a) abgeschiedenen Folie vorhandenen Silicium-Sauerstoff-Bindungen durch ein chemisches Mittel.

2. Verfahren nach Anspruch 1, wobei das Material, aus dem die Folie besteht, vom Typ SiᵥC_{w}H_{y}O_{z} oder SiᵥC_{w}NₓH_{y}O_{z} mit v, w, x, y und z jeweils verschiedenen von 0, ist.

3. Verfahren nach Anspruch 1 oder Anspruch 2, wobei die Folie durch plasmaunterstützte chemische Dampfphasenabscheidung auf das Substrat abgeschieden wird.

4. Verfahren nach Anspruch 3, wobei die Folie vom Typ SiᵥC_{w}H_{y}O_{z} ist und deren Abscheidung auf das Substrat unter Verwendung von einem Plasma erfolgt, das einen ersten Organosilicium-Vorläufer, der frei von Sauerstoff ist, und einen zweiten Organosilicium-Vorläufer enthält, der aus Sauerstoff allein oder in Kombination mit Kohlenstoff und/oder Wasserstoff besteht.

5. Verfahren nach Anspruch 4, wobei der erste Vorläufer ein Alkylsilan ist und der zweite Vorläufer Sauerstoff oder Kohlendioxid ist.

6. Verfahren nach Anspruch 3, wobei die Folie vom Typ SiᵥC_{w}NₓH_{y}O_{z} ist und deren Abscheidung auf das Substrat unter Verwendung von einem Plasma erfolgt, das einen ersten Organosilicium-Vorläufer, der frei von Sauerstoff ist, einen zweiten Organosilicium-Vorläufer, der aus Sauerstoff allein oder in Kombination mit Kohlenstoff und/oder Wasserstoff besteht, sowie einen dritten Vorläufer enthält, der aus Stickstoff allein oder in Kombination mit Wasserstoff und/oder Kohlenstoff besteht.

7. Verfahren nach Anspruch 6, wobei der erste Vorläufer ein Alkylsilan ist, der zweite Vorläufer Sauerstoff oder Kohlendioxid ist und der dritte Vorläufer Stickstoff oder Ammoniak ist.

8. Verfahren nach einem der vorangehenden Ansprüche, wobei das in Schritt b) verwendete chemische Mittel ein Fluid mit Fluorwasserstoffsäure ist.

9. Verfahren nach Anspruch 8, wobei das Fluorwasserstoffsäure enthaltende Fluid eine wässrige oder organische Fluorwasserstoffsäure-Lösung ist.

10. Verfahren nach Anspruch 8, wobei das Fluorwasserstoffsäure enthaltende Fluid reine gasförmige Fluorwasserstoffsäure, ein Gemisch aus gasförmiger Fluorwasserstoffsäure und einem Trägergas oder ein Gemisch aus Fluorwasserstoffsäure und superkritischem Kohlendioxid ist.

11. Verfahren nach einem der Ansprüche 1 bis 7, wobei das in Schritt b) verwendete chemische Mittel ein Ammoniumfluorid enthaltendes Fluid ist.

12. Verfahren nach einem der vorangehenden Ansprüche, wobei das Substrat ein Siliciumsubstrat ist, das Siliciumoxidstrukturen enthält oder nicht.

13. Verfahren nach einem der vorangehenden Ansprüche, wobei es zum Erhalt einer dielektrischen Folie mit einer Dielektrizitätskonstante k von unter oder gleich 4,0 führt.

14. Verfahren zum Herstellen von Verbindungen mit Luftkammern für eine integrierte Schaltung, das das Durchführen eines Verfahrens nach einem der Ansprüche 1 bis 13 umfasst.

## Claims

1. Process for manufacturing a permeable dielectric film, which comprises:
a) the deposition on a substrate of a film constituted of a material comprising silicon, carbon, hydrogen, oxygen and, possibly, nitrogen and/or fluorine, in which more than 50% of the bonds formed by the silicon atoms are silicon-carbon bonds and in which the proportion of silicon-oxygen bonds is such that the oxygen present in said material represents less than 30% by number of atoms; and then
b) the selective destruction with a chemical agent of the silicon-oxygen bonds present in the film deposited in step a).

2. Process according to claim 1, in which the material constituting the film is of the type SiᵥC_{w}H_{y}O_{z} or SiᵥC_{w}NₓH_{y}O_{z} with v, w, x, y and z all other than 0.

3. Process according to claim 1 or claim 2, in which the film is deposited on the substrate by plasma-enhanced chemical vapour deposition.

4. Process according to claim 3, in which the film is of the type SiᵥC_{w}H_{y}O_{z} and its deposition on the substrate is performed using a plasma containing a first organosilicon precursor free of oxygen and a second precursor constituted of oxygen, alone or in combination with carbon and/or hydrogen.

5. Process according to claim 4, in which the first precursor is an alkylsilane and the second precursor is oxygen or carbon dioxide.

6. Process according to claim 3, in which the film is of the type SiᵥC_{w}NₓH_{y}O_{z} and its deposition on the substrate is performed using a plasma containing a first organosilicon precursor free of oxygen, a second precursor constituted of oxygen, alone or in combination with carbon and/or hydrogen, and a third precursor constituted of nitrogen, alone or in combination with hydrogen and/or carbon.

7. Process according to claim 6, in which the first precursor is an alkylsilane, the second precursor is oxygen or carbon dioxide and the third precursor is nitrogen or ammonia.

8. Process according to any one of the preceding claims, in which the chemical agent used in step b) is a fluid containing hydrofluoric acid.

9. Process according to claim 8, in which the fluid containing hydrofluoric acid is an aqueous or organic hydrofluoric acid solution.

10. Process according to claim 8, in which the fluid containing hydrofluoric acid is pure hydrogen fluoride gas, a mixture of hydrogen fluoride gas and of a carrier gas, or a mixture of hydrofluoric acid and of supercritical carbon dioxide.

11. Process according to any one of claims 1 to 7, in which the chemical agent used in step b) is a fluid containing ammonium fluoride.

12. Process according to any one of the preceding claims, in which the substrate is a silicon substrate comprising or not silicon oxide structures.

13. Process according to any one of the preceding claims, which leads to the production of a dielectric film with a dielectric constant k of less than or equal to 4.0.

14. Process for manufacturing air-gap interconnects for integrated circuits, which comprises the implementation of a process according to any one of claims 1 to 13.
